(19) Europäisches Patentamt

**European Patent Office**

**Office européen des brevets**

(11) Numéro de publication: **0 366 517 B1**

(12) **FASCICULE DE BREVET EUROPEEN**

(45) Date de publication de fascicule du brevet: **20.04.94** (51) Int. Cl.⁵: **H03M 1/36**, H03M 1/00

(21) Numéro de dépôt: **89402785.3**

(22) Date de dépôt: **10.10.89**

(54) Convertisseur analogique-numérique parallèle, à circuit de correction d'erreur.

(30) Priorité: **14.10.88 FR 8813539**

(43) Date de publication de la demande:
**02.05.90 Bulletin 90/18**

(45) Mention de la délivrance du brevet:
**20.04.94 Bulletin 94/16**

(84) Etats contractants désignés:
**DE GB NL**

(56) Documents cités:
**US-A- 4 586 025**
**US-A- 4 712 087**

(73) Titulaire: **THOMSON-CSF SEMICONDUCTEURS SPECIFIOUES**
**173, Boulevard Haussmann**
**F-75008 Paris(FR)**

(72) Inventeur: **Nguyen, Truong-Thao**
**THOMSON-CSF**
**SCPI**
**Cédex 67**
**F-92045 Paris la Défense(FR)**
Inventeur: **Thomas, François**
**THOMSON-CSF**
**SCPI**
**Cédex 67**
**F-92045 Paris la Défense(FR)**

(74) Mandataire: **Taboureau, James et al**
**THOMSON-CSF,**
**SCPI,**
**B.P. 329,**
**50, rue Jean-Pierre Timbaud**
**F-92402 Courbevoie Cédex (FR)**

EP 0 366 517 B1

Rank Xerox (UK) Business Services
(3.10/3.09/3.3.3)

## Description

La présente invention concerne un perfectionnement aux convertisseurs analogiques-numériques parallèles, appelés "flash" : ce perfectionnement consiste à introduire un étage de correction logique placé entre l'étage des comparateurs et l'étage de l'encodeur. Cet étage de correction force la sortie d'un comparateur, qui est accidentellement erronée, à prendre la même valeur logique, 0 ou 1, que les sorties des deux comparateurs voisins si celles-ci sont identiques.

En d'autres termes, le circuit de correction selon l'invention force à O logique la sortie d'un comparateur qui fournit un 1 logique, tandis que les deux comparateurs qui l'encadrent fournissent tous deux un 0 logique. Et réciproquement, il force à 1 logique la sortie d'un comparateur qui fournit un 0 logique si les deux comparateurs qui l'encadrent fournissent un 1 logique.

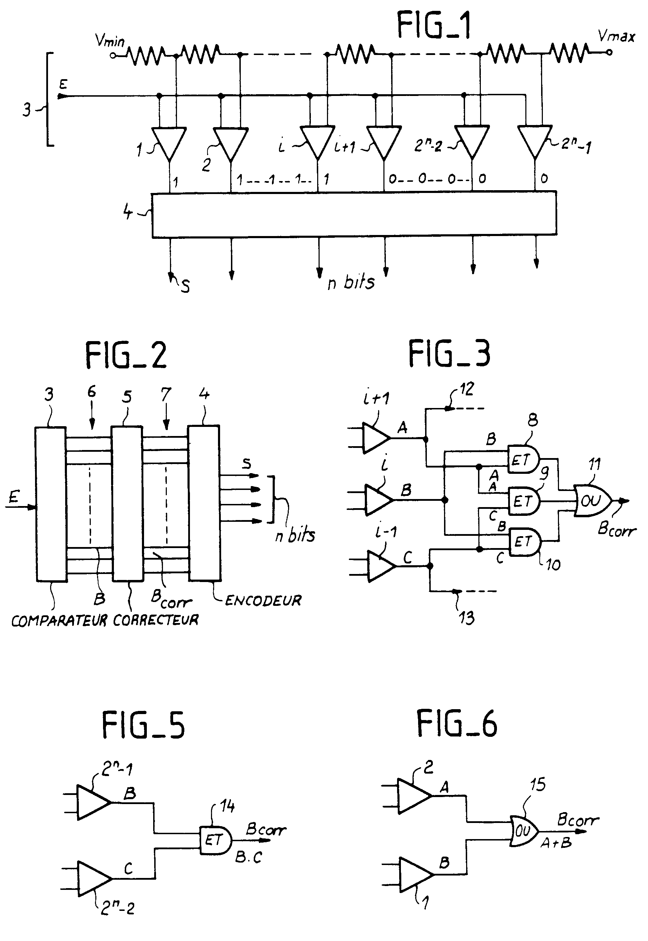

On sait qu'un convertisseur analogique-numerique de type "flash" -il existe d'autres structures de CAN- comporte, tel que très sommairement rappelé en figure 1, un premier étage de comparateurs montés en parallèle et repérés $1,2...i,i + 1,... 2^n-2, 2^n-1$, si le CAN doit fournir un signal logique formé de n bits. Le signal analogique à convertir, à l'entrée E, est appliqué en parallèle sur toutes les premières entrées des comparateurs. Des tensions de références, par valeurs discrètes égales, sont prélevées sur un diviseur de tension entre $V_{min}$ et $V_{max}$ et appliquées sur les deuxièmes entrées des comparateurs.

L'ensemble des comparateurs et du diviseur de tension forme l'étage comparateur, repéré 3, qui fournit ce qu'il est d'usage d'appeler une échelle thermométrique. C'est à dire que toutes les sorties de comparateurs pour lesquels la tension analogique est supérieure à la tension de référence fournissent un signal 1 logique. Réciproquement, toutes les sorties de comparateurs pour lesquels la tension analogique est inférieure à la tension de référence fournissent un signal 0 logique.

L'ensemble de ces $(2^n -1)$ valeurs logiques, c'est à dire une série de 1 logique suivie par une série de 0 logique, ou échelle thermométrique, est adressé à un étage encodeur 4 qui fournit un nombre binaire de "n" bits.

En fait, et surtout dans le domaine des hyperfréquences, avec un signal analogique oscillant entre 1 et 100 GHz, il arrive que les comparateurs ne travaillent pas de façon parfaite, et que l'un d'entre eux fournisse accidentellement un 1 logique au lieu d'un 0 logique, ou inversement. De tels accidents sont dûs par exemple à un parasite pendant seulement une mesure -tous les comparateurs sont pilotés par une horloge- ou encore parce qu'un comparateur est isolé, en cours de calibration et donc temporairement hors d'état de fonctionner.

L'invention consiste donc à introduire, dans un convertisseur analogique-numérique, un étage correcteur entre l'étage comparateur (entrée du CAN) et l'étage encodeur (sortie du CAN). Cet étage correcteur force la sortie d'un comparateur à prendre la même valeur logique que celles des deux comparateurs qui l'encadrent si et seulement si lesdites deux valeurs logiques sont identiques, mais opposées à celle fournie par le comparateur considéré, qui est accidentellement erronée.

De façon plus concrète, si au sein d'une série de 1 logique, un comparateur sort accidentellement un 0 logique, le circuit correcteur selon l'invention corrige cet accident et fournit un 1 logique. De même, si un 1 logique se trouve au milieu d'une série de 0 logique, le circuit correcteur corrige cet accident et fournit un 0 logique.

Le circuit correcteur selon l'invention est adapté au cas des deux comparateurs d'extrêmités, qui n'ont qu'un seul voisin : comparateur 1 de bit de poids le plus léger, et comparateur $2^n - 1$ de bit de poids le plus lourd.

De façon plus précise, l'invention concerne un convertisseur analogique-numérique selon la revendication 1. Un convertisseur analogique-numérique parallèle selon le préambule est connu du document US-A-4 712 087.

L'invention sera mieux comprise par la description détaillée qui est faite maintenant d'un exemple de réalisation, cette description s'appuyant sur les figures jointes en annexe, qui représentent :
- figure 1 : schéma électrique, déjà exposé, d'un convertisseur analogique-numérique selon l'art connu,
- figure 2 : schéma en diagramme de blocs d'un CAN selon l'art connu de US-A-4 712 087
- figure 3 : schéma électrique d'une cellule élémentaire de correction selon l'invention
- figure 4 : schéma électrique d'un fragment central de l'étage de correction selon l'invention,
- figure 5 : schéma électrique de la cellule élémentaire de correction, pour l'extrêmité de bit de poids le plus léger, selon l'invention,
- figure 6 : schéma électrique de la cellule élémentaire de correction, pour l'extrêmité de bit de poids le plus lourd, selon l'invention.
- figure 7 : schéma d'ensemble de l'étage de correction dans un CAN selon l'invention.

D'après ce qui a été dit précédemment, fondamentalement c'est la position de la transition entre la série de 1 logiques et la série de 0 logiques, dans l'échelle thermométrique d'un CAN flash, qui permet à l'encodeur 4 de déterminer le nombre binaire de conversion.

S'il y a plus d'une transition , c'est à dire s'il y a au moins une transition accidentelle telle que :

$$11 \ldots 1\overset{\prime}{0}1 \ldots 1100 \ldots 00$$

$$\text{ou} \qquad 11 \ldots 1100 \ldots 0\overset{\prime}{1}0 \ldots 00$$

il faut corriger la sortie du comparateur qui fournit une valeur accidentellement erronée.

Ceci est obtenu grâce à l'invention, selon laquelle un CAN représenté en figure 3 combinée avec la figure 2 est modifié par adjonction, entre l'étage comparateur 3 et l'étage encodeur 4 - qui sont tout à fait classiques - d'un étage correcteur 5. L'étage comparateur 3 fournit en 6 une échelle thermométrique qui est, accidentellement, entâchée d'une erreur sur une sortie qu'on appelera B : l'étage correcteur selon l'invention fournit en 7 une échelle thermométrique corrigée, dont la valeur B corrigée est correcte.

L'implantation d'un tel circuit est simple. De même que l'étage comparateur 3 est formé par une pluralité de comparateurs 1... $(2^n - 1)$ mis en parallèle, l'étage correcteur 5 est formé par une pluralité de circuits, mis en parallèle, qu'on conviendra, pour simplifier l'écriture, d'appeler "cellules". Pour corriger - si nécessaire - la valeur de sortie de chaque comparateur, la cellule de correction correspondant à cette sortie la compare aux valeurs de sorties des deux comparateurs voisins, qui l'encadrent, tel que représenté en figure 3.

Considérons un comparateur de rang i, et appelons B la valeur booléenne de sa sortie. Appelons A et C les valeurs booléennes des sorties des deux comparateurs vosins de rang i + 1 et i-1, respectivement. La cellule de correction compare B à A et C et doit forcer B à 0 logique dès que A = C = 0 logique, ou forcer B à 1 logique dès que A = C = 1 logique, mais doit conserver B dans les autres cas.

Ce critère est satisfait par la fonction booléenne

$B_{corrigé}$ = (A et C) ou [B et (A ou C)]

qui s'écrit

$B_{corr}$ = A.C + B. (A + C)
ou
$B_{corr}$ = A.C + B.A + B.C

A.C représente le forçage à 1 si et seulement si A = C = 1
En effet, si A = C = 1, A.C = 1
B. (A + C)représente le forçage à 0 si et seulement si A = C = 0
Il en résulte le tableau suivant :

| A | C | A.C | B.(A + C) | $B_{corr}$ |
|---|---|-----|-----------|------------|
| 1 | 1 | 1 | ? | 1 |
| 0 | 0 | 0 | 0 | 0 |
| 0 | 1 | 0 | B | B |
| 1 | 0 | 0 | B | B |

Les deux dernières lignes montrent que le circuit de correction n'intervient que si A = C = 1 ou si A = C = 0. Dans les autres cas, il ne corrige pas B : $B_{corr}$ = B.

Cette même fonction booléenne est satisfaite par la table de vérité de $B_{corr}$ :

| A | 0 | 1 | 0 | 1 | 0 | 1 | 0 | 1 |
|---|---|---|---|---|---|---|---|---|
| B | 0 | 0 | 1 | 1 | 0 | 0 | 1 | 1 |
| C | 0 | 0 | 0 | 0 | 1 | 1 | 1 | 1 |
| $B_{corr}$ | 0 | 0 | 0 | 1 | 0 | 1 | 1 | 1 |

La troisième colonne montre qu'il y a forçage à 0 logique, et la sixième colonne forçage à 1 logique.

Pour en revenir à la figure 3, chaque cellule de l'étage correcteur 5 comporte :

- trois portes ET 8,9 et 10, montées en parallèle,
- une porte OU 11, en série avec les trois portes ET.

La sortie B du comparateur i est adressée aux premières entrées (B) des première et troisième portes ET 8 et 10.

La sortie A du comparateur i + 1 est adressée à la deuxième entrée (a) de la première porte ET 8 et à la première entrée (A) de la deuxième porte ET 9.

La sortie C du comparateur i-1 est adressée à la deuxième entrée (C) de la troisième porte ET 10 et à la deuxième entrée (C) de la deuxième porte ET 9.

Ainsi, la première porte ET 8 fournit en sortie la fonction booléenne A.B (A etB), la deuxième porte 9 fournit la fonction A.C (A et C) et la troisième porte 10 fournit la fonction B.C (B et C).

Les sorties des trois portes ET 8,9,10 sont adressées aux entrées de la porte OU 11, dont la sortie fournit la valeur $B_{corrigé}$.

Ce circuit vérifie bien la fonction booléenne

$$B_{corr} = (A.B) \text{ ou } (A.C) \text{ ou } (B.C)$$

Etant donné qu'il faut 1 cellule de correction 8 + 9 + 10 + 11 pour un comparateur de rang i, les sorties A du comparateur de rang i + 1 et C du comparateur de rang i - 1 sont adressées, en 12 et 13 respectivement, à deux cellules de correction, qui fournissent $A_{corrigé}$ et $C_{corrigé}$.

Au schéma itératif de l'étage de comparateurs 3 correspond un schéma itératif de l'étage correcteur 5, dont un fragment est représenté en figure 4. Cette figure met en évidence que l'étage correcteur est formé d'un sous-étage de portes ET, en série avec un sous-étage de portes OU.

Elle montre également que le comparateur :

- de rang i est associé à une cellule 8 + 9 + 10 + 11
- de rang i + 1 est associé à une cellule 18 + 19 + 20 + 21
- de rang i - 1 est associé à une cellule 28 + 29 + 30 + 31

On constate que deux portes ET 8 et 20 ou 10 et 28 sont voisines et fournissent toutes deux la même fonction, A.B ou B.C respectivement. La logique booléenne permet de simplifier ce schéma, mais en fait cette simplification entraine une complication de réalisation technologique, pour le multiplexage de la sortie d'une porte ET entre les entrées de deux portes OU, qui ne la rend pas intéressante.

Les deux comparateurs extrêmes dans l'échelle thermométrique présentent un cas particulier puisqu'ils n'ont qu'un seul voisin. Les cellules de correction en sont représentées en figures 5 et 6.

La figure 5 correspond au comparateur de plus fort poids, de rang $2^n-1$, ou "du haut" de l'échelle thermométrique. Pour celui-ci, on se contente d'interdire le 1 logique, c'est à dire qu'on le force à 0 logique, dès lors que son voisin de rang $2^n - 2$ fournit un 0 logique. Dans la première fonction booléenne écrite plus haut, c'est

[B et (A ou C)]

qui représente le forçage à 0 logique. Comme A n'existe pas, il suffit d'une porte ET 14 qui fournit B.C.

Pour le comparateur de plus faible poids, en figure 6, soit le comparateur 1 dans l'échelle thermométrique, l'opération est analogue : on interdit la valeur O logique, ou on force sa sortie à 1 logique, dès lors que le comparateur de rang 2 fournit un 1 logique. Une porte OU 15 remplit cette fonction.

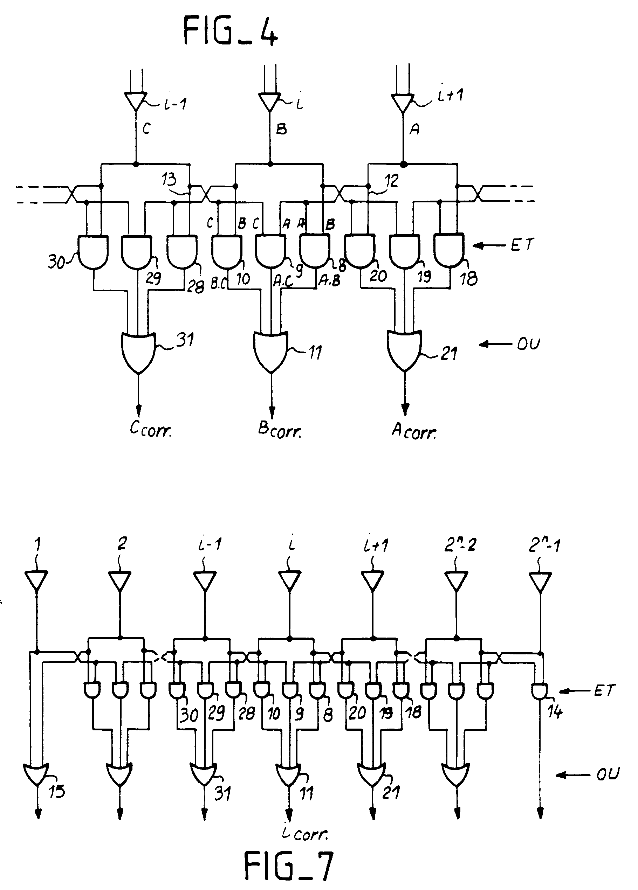

La figure 7 donne le schéma électrique d'ensemble de l'étage correcteur d'un CAN flash, y compris ses deux cellules extrêmes, qui sont limitées à :

- une porte OU 15 pour le convertisseur 1 de poids le plus léger,
- une porte ET 14 pour le convertisseur $2^n$-1 de poids le plus lourd.

Cet étage correcteur est appliqué à la réalisation de CAN flash, surtout ceux qui sont intégrés sur matériaux rapides du groupe III-V tel que GaAs, mais son schéma reste valable pour des CAN flash moins rapides, sur silicium, en circuit intégré ou en éléments discrets.

## Revendications

1. Convertisseur analogique-numérique parallèle, dit "flash", comportant un premier étage (3) formé d'une pluralité de comparateurs (1 à $2^n$-1) montés en parallèle qui transforment une valeur analogique appliquée à leur entrée commune (E) en une valeur binaire constituée par une suite de 1 logiques puis de 0 logiques dite échelle thermométrique (6), et comportant également un second étage (4) encodeur, qui transforme les valeurs de l'échelle thermométrique (6) en un nombre binaire, ce convertisseur étant caractérisé en ce qu'il comporte en outre, inséré entre le premier (3) et le second (4) étage, un troisième étage (5), correcteur, dont la fonction est de corriger la valeur de sortie B d'un comparateur de rang "i" qui est accidentellement erronée et présente une anomalie dans l'échelle thermométrique (6) par rapport aux valeurs de sorties A et C des deux comparateurs de rang i-1 et i + 1 qui l'encadrent, ce troisième étage correcteur (5) forçant la sortie B du comparateur de rang i à prendre la même valeur corrigée B $_{corr}$ que les sorties A et C des deux comparateurs de rang i + 1 et i + 1 si et seulement si ces deux valeurs de sorties A et C sont égales et opposées à la valeur de sortie B du comparateur de rang i, vérifiant la fonction booléenne :

   $B_{corr}$ = (A et C) ou [B et (A ou C)]
   ou
   $B_{corr}$ = A.C. + B.A + B.C

2. Convertisseur selon la revendication 1, caractérisé en ce que le troisième étage correcteur (5) comporte une pluralité de portes ET (8,9,10), montées en parallèle, dont les sorties sont adressées trois par trois, sur une porte OU (11) qui délivre une valeur corrigée $B_{corr}$.

3. Convertisseur selon la revendication 1, caractérisé en ce que le troisième étage correcteur (5) comporte une pluralité de cellules de correction égale à la pluralité de comparateurs (1 à $2^n$ - 1) du premier étage (3), la sortie B de chaque comparateur étant adressée à une cellule de correction qui, s'il y a anomalie dans l'échelle thermométrique (6), fournit une valeur corrigée $B_{corr}$.

4. Convertisseur selon la revendication 3, dont A,B et C sont les valeurs de sorties, respectivement, de trois comparateurs voisins de rangs i + 1, i et i-1, caractérisé en ce qu'à un comparateur de rang i correspond dans le troisième étage, une cellule de correction, constituée par :
   - un sous-étage de trois portes ET (8,9,10) montées en parallèle,
   - un sous-étage d'une porte OU (11), en série avec les trois portes ET (8,9,10), qui fournit la valeur de sortie $B_{corr}$.
   - les valeurs de sortie A,B et C des trois comparateurs étant adressées : A et B sur la première porte ET (8), A et C sur la deuxième porte ET (9), B et C sur la troisième porte ET (10).

5. Convertisseur selon la revendication 3, caractérisé en ce que, pour le comparateur ($2^n$ - 1) de poids le plus fort, la cellule de correction qui lui est associée est constituée par une unique porte ET (14), qui reçoit sur ses entrées les valeurs de sorties respectivement B et C dudit comparateur ($2^n$ - 1) et du comparateur ($2^n$ - 2) de poids immédiatement inférieur, et qui fournit une valeur de sortie $B_{corr}$.

6. Convertisseur selon la revendication 3, caractérisé en ce que, pour le comparateur (1) de poids le plus faible, la cellule de correction qui lui est associée est constituée par une unique porte OU (15), qui reçoit sur ses entrées les valeurs de sorties, respectivement, B et A dudit comparateur (1) et du comparateur (2) de poids immédiatement supérieur, et qui fournit une valeur de sortie $B_{corr}$.

## Claims

1. So-called "flash" parallel analog/digital converter, including a first stage (3) formed of a plurality of parallel-mounted comparators (1 to $2^n$-1) which convert an analog value applied to their common input

5

(E) into a binary value consisting of a sequence of logic 1s then logic 0s, termed a thermometer scale (6), and also including a second encoder stage (4) which converts the values of the thermometer scale (6) into a binary number, this converter being characterized in that it furthermore includes, inserted between the first (3) and the second (4) stage, a third, corrector, stage (5), the function of which is to correct the output value B from a comparator of rank "i" which is mistakenly erroneous and exhibits an anomaly in the thermometer scale (6) with respect to the output values A and C from the two comparators of rank i-1 and i+1 which flank it, this third corrector stage (5) forcing the output B from the comparator of rank i to take the same corrected value $B_{corr}$ as the outputs A and C from the two comparators of rank i+1 and i-1 if and only if these two output values A and C are equal, and opposite to the output value B from the comparator of rank i, satisfying the Boolean function:

$B_{corr}$ = (A and C) or [B and (A or C)]
or
$B_{corr}$ = A.C. + B.A + B.C

2.  Converter according to Claim 1, characterized in that the third corrector stage (5) includes a plurality of AND gates (8, 9, 10), mounted in parallel, the outputs of which are addressed, in threes, to an OR gate (11) which delivers a corrected value $B_{corr}$.

3.  Converter according to Claim 1, characterized in that the third corrector stage (5) includes a plurality of correction cells equal to the plurality of comparators (1 to $2^n$-1) of the first stage (3), the output B from each comparator being addressed to a correction cell which, if there is an anomaly in the thermometer scale (6), supplies a corrected value $B_{corr}$.

4.  Converter according to Claim 3, wherein A, B and C are the output values from three neighbouring comparators of ranks i+1, i and i-1 respectively, characterized in that to a comparator of rank i there corresponds in the third stage a correction cell consisting of:
    - a sub-stage of three parallel-mounted AND gates (8, 9, 10),
    - a sub-stage of an OR gate (11), in series with the three AND gates (8, 9, 10) which supplies the output value $B_{corr}$,
    - the output values A, B and C from the three comparators being addressed: A and B to the first AND gate (8), A and C to the second AND gate (9), B and C to the third AND gate (10).

5.  Converter according to Claim 3, characterized in that, for the highest significance comparator ($2^n$-1), the correction cell associated therewith consists of a single AND gate (14) which receives on its inputs the output values B and C from the said comparator ($2^n$-1) and from the comparator ($2^n$-2) of immediately lower significance respectively, and which supplies an output value $B_{corr}$.

6.  Converter according to Claim 3, characterized in that, for the lowest significance comparator (1), the correction cell associated therewith consists of a single OR gate (15) which receives on its inputs the output values B and A from the said comparator (1) and from the comparator (2) of immediately higher significance, respectively, and which supplies an output value $B_{corr}$.

**Patentansprüche**

1.  Paralleler Analog-Digital-Wandler vom "Flash"-Typ, mit einer ersten Stufe (3), die aus einer Mehrzahl von Komparatoren (1 bis $2^n$-1) in Parallelschaltung besteht und einen an einen gemeinsamen Eingang (E) angelegten Analogwert in einen aus einer Folge von logischen 1 und einer anschließenden Folge von logischen 0 bestehenden Digitalwert verwandelt, Thermometerskala (6) genannt, und mit einer zweiten Stufe (4), Kodierstufe genannt, die die Werte der Thermometerskala (6) in eine Binärzahl verwandelt, dadurch gekennzeichnet, daß der Wandler außerdem zwischen der ersten (3) und der zweiten Stufe (4) eine dritte Stufe (5), Korrekturstufe genannt, enthält, deren Aufgabe es ist, den Wert am Ausgang B eines Komparators des Rangs "i" zu korrigieren, der versehentlich fehlerhaft ist und eine Anomalie der Thermometerskala (6) bezüglich der Ausgangswerte A und C der beiden benachbarten Komparatoren des Rangs i-1 und i+1 darstellt, wobei diese Korrekturstufe (5) den Ausgang B des Komparators des Rangs i denselben korrigierten Wert $B_{korr}$ annehmen läßt, wie die Ausgänge A und C der beiden Komparatoren des Rangs i+1 und i-1, wenn und nur wenn diese beiden Ausgangswerte A und C gleich sind und dem Wert des Ausgangs B des Komparators des Rangs i entgegengesetzt sind, so daß die Boole'sche Funktion erfüllt wird:

$B_{korr}$ = (A und C) oder [B und (A oder C)]
oder
$B_{korr}$ = A.C + B.A + B.C.

2. Wandler nach Anspruch 1, dadurch gekennzeichnet, daß die Korrekturstufe (5) eine Mehrzahl von UND-Toren (8, 9, 10) in Parallelschaltung enthält, deren Ausgänge in Gruppen von drei an ein ODER-Tor (11) angeschlossen sind, das einen korrigierten Wert $B_{korr}$ liefert.

3. Wandler nach Anspruch 1, dadurch gekennzeichnet, daß die Korrekturstufe (5) eine Anzahl von Korrekturzellen gleich der Anzahl von Komparatoren (1 bis $2^n$-1) der ersten Stufe (3) enthält, wobei der Ausgang B jedes Komparators an eine Korrekturzelle angeschlossen ist, die im Fall einer Anomalie der Temperaturskala (6) einen korrigierten Wert $B_{korr}$ liefert.

4. Wandler nach Anspruch 3, in dem A, B und C Ausgangswerte von drei benachbarten Komparatoren des Rangs i+1, i und i-1 sind, dadurch gekennzeichnet, daß ein Komparator des Rangs i in der Korrekturstufe eine Korrekturzelle enthält, die besteht aus
   - einer Unterstufe von drei UND-Toren (8, 9, 10) in Parallelschaltung,
   - einer Unterstufe eines ODER-Tors (11) in Reihe mit den drei UND-Toren (8, 9, 10), die den Ausgangswert $B_{korr}$ liefert,
   wobei die Ausgangswerte A, B und C der drei Komparatoren folgendermaßen angeschlossen sind: A und B an das erste UND-Tor (8), A und C an das zweite UND-Tor (9), B und C an das dritte UND-Tor (10).

5. Wandler nach Anspruch 3, dadurch gekennzeichnet, daß die Korrekturzelle, die dem Komparator ($2^n$-1) höchsten Gewichts zugeordnet ist, aus einem einzigen UND-Tor (14) besteht, das an seinen Eingängen die Ausgangswerte B und C dieses Komparators ($2^n$-1) und des Komparators ($2^n$-2) des unmittelbar nächstniedrigeren Gewichts empfängt und eine Ausgangswert $B_{korr}$ liefert.

6. Wandler nach Anspruch 3, dadurch gekennzeichnet, daß die Korrekturzelle, die dem Komparator (1) mit geringstem Gewicht zugeordnet ist, aus einem einzigen ODER-Tor (15) besteht, das an seinen Eingängen die Ausgangswerte B und A dieses Komparators (1) und des Komparators (2) mit dem nächsthöheren Gewicht empfängt und einen Ausgangswert $B_{korr}$ liefert.

FIG_1

FIG_2

FIG_3

COMPARATEUR CORRECTEUR — ENCODEUR

FIG_5

FIG_6

## FIG_4

## FIG_7